(19) Europäisches Patentamt
European Patent Office
Office européen des brevets

(11) **EP 1 381 257 B1**

(12) **EUROPEAN PATENT SPECIFICATION**

(45) Date of publication and mention
of the grant of the patent:
**06.05.2015  Bulletin 2015/19**

(51) Int Cl.:
***H05H 1/24*** *(2006.01)*      ***H01J 37/32*** *(2006.01)*

(21) Application number: **03077169.5**

(22) Date of filing: **10.07.2003**

(54) **Apparatus for producing and sustaining a glow discharge plasma under atmospheric conditions**

Vorrichtung zur Erzeugung und Erhaltung einer Glimmentladungsplasma unter atmosphärischen Bedingungen

Dispositif d'amorçage et de maintien d'un plasma à décharge luminescente sous conditions atmosphériques

(84) Designated Contracting States:
**AT BE BG CH CY CZ DE DK EE ES FI FR GB GR HU IE IT LI LU MC NL PT RO SE SI SK TR**

(30) Priority: **11.07.2002  US 192860**

(43) Date of publication of application:
**14.01.2004  Bulletin 2004/03**

(73) Proprietor: **FUJIFILM Manufacturing Europe B.V.**
**5047 TK Tilburg (NL)**

(72) Inventors:
 • **Van de Sanden, Mauritius Cornelius Maria**
  **5017 JC Tilburg (NL)**
 • **Aldea, Eugen**
  **5616 GK Tilburg (NL)**
 • **Mori, Fuyuhiko**
  **5045 SH Tilburg (NL)**
 • **De Vries, Hindrik Willem**
  **5045 CM Tilburg (NL)**

(74) Representative: **Algemeen Octrooi- en Merkenbureau B.V.**
**P.O. Box 645**
**5600 AP Eindhoven (NL)**

(56) References cited:
EP-A- 1 022 933      US-A- 4 664 890
US-A- 4 679 007      US-A- 5 474 648
US-A- 5 747 935      US-A- 5 882 492
US-A- 5 895 558      US-A- 5 965 034

## Description

Field of the Invention

The present invention relates generally to discharge plasma systems, and more specifically to an apparatus for generating a glow discharge plasma under atmospheric pressure conditions.

Background of the Invention

Atmospheric Pressure Glow (APG) discharge is used in practice, among others, for non-destructive material surface modification. Glow discharge plasmas are relatively low power density plasmas, typically generated under atmospheric pressure conditions or partial vacuum environments.

Most commonly, the plasma is generated in a plasma chamber or plasma discharge space between two oppositely arranged parallel plate electrodes. However, the plasma may also be generated using other electrode configurations such as, for example, adjacently arranged electrodes. The plasma is generated in a gas or a gas mixture by energizing the electrodes from AC power supply means.

It has been observed that a stable and uniform plasma can be generated in, for example, a pure Helium or a pure Nitrogen gas. However, as soon as impurities or other gasses or chemical compositions at ppm level are present in the gas, the stability of the plasma will decrease significantly. Typical examples of stability destroying components are $O_2$, NO, $CO_2$, etc..

Instabilities in the plasma will either develop in a high current density plasma or will extinguish the plasma locally. With a large density of species and a high frequency of collisions in the plasma, an APG shows a fast positive feedback. That is, a random local increase of the ionization of the plasma will exponentially increase. Accordingly, an instability will develop either in a high current density plasma or will extinguish locally the plasma. This phenomenon of exponential increase of the plasma current is known as glow to arc transition. As a result, current arcing occurs and the glow discharge plasma can not be maintained. Instead, a combination of filamentary and glow discharge is generated.

Filamentary discharge between parallel plate electrodes in air under atmospheric pressure has been used to generate ozone in large quantities but is of limited use for surface treatment of materials, since the plasma filaments tend to puncture or treat the surface unevenly and are associated with relatively high plasma currents.

Electrically, an APG system or an APG reactor can be represented or modeled by an equivalent RLC-circuit diagram, comprising a capacitance C, mainly due to the capacitance of the spaced electrodes, an inductance L and a plasma resistance R. The inductance component includes the APG self-inductance and the equivalent inductance of the coupling of the system to the power supply. When the APG system is coupled by a transformer to a power supply, the equivalent inductance of the coupling is of a significant order of at least a few mH. At plasma breakdown, large resonance current oscillations can be generated due to the RLC-circuit. These current oscillations provide a major risk for plasma stability, setting a ground for the generation of waves in the plasma and the constriction of the plasma column.

US 5,414,324 discloses a plasma chamber having a first or upper electrode through which air is injected and a second or counter electrode on which the substrate to be treated is located. For protecting the substrate to be treated against sparks, i.e. current arcing in the plasma, an electrically conductive grid is provided between the oppositely spaced electrodes. This grid is connected by an inductor having a large inductance. From experiments disclosed by US 5,414,324 it appears that, for practical use, an inductor having an inductance of 100 H and even higher has to be applied.

Due to the high value of the inductance, the time constant of the LC-circuit formed by the high inductance and the stray capacity of the APG reactor and the grid will be in the range of milliseconds. Therefore, the known circuit can not give any feedback to fast processes like the resonance current oscillations at plasma breakdown and the glow to arc transitions, which are produced within fractions of a microsecond. That is, a spark is already present when the inductor starts to react.

Those skilled in the art will appreciate that the combination of a conductive grid and a high inductance is a design which can be used only for over-current protection, being in fact a solution for damping the current of the sparks already developed in the plasma and preventing that the sparks will reach the counter electrode, where the material to be treated by the plasma is located.

Further, during breakdown, the plasma is in its most unstable phase in which even small voltage variations can easily affect plasma stability. By introducing a relatively large inductance, such as disclosed by US 5,414,324, the voltage variations will be large and, as consequence, the plasma stability will be adversely affected. Besides that, when the plasma develops explosively at its breakdown, decreasing the voltage is not a guarantee that the current will start to decrease. Near breakdown, the plasma has a negative resistance such that the current in fact will increase faster if the voltage is decreased.

The solution disclosed by US 5,414,324 therefore can only have a small effect at normal low current operating conditions and can affect only very slightly the plasma stability and will not protect against the formation of sparks.

Further, inductors of the size disclosed above require a relatively large amount of space and, due to the magnetic core required, have a significant weight. The conductive grid limits the effective discharge space for treating a substrate by the plasma.

US patent no. 5,895,558 is directed to discharge methods and electrodes for generating plasma's at one atmosphere of pressure, and materials treated therewith.

US patent no. 4,679,007 is directed to improvements to an impedance matching network for matching the impedance of a power supply to the variable impedance of a plasma.

US patent no. US 5,882,492 discloses a plasma processing system comprising an AC power supply. The power supply is based on a DC power supply wherein the DC signal is converted to an AC signal by means of a suitable switching arrangement. For stabilising the plasma, US 5,882,492 discloses to provide a dwell time between consecutive plasma pulses.

US patent no. US 5,965,034 is directed to a high frequency plasma process wherein the plasma is executed by an inductive structure in which the phase and anti-phase portion of the capacitive currents between the inductive structure and the plasma are balanced.

Summary of the Invention

It is an object of the present invention to provide a novel and improved apparatus for producing and sustaining a uniform atmospheric glow discharge plasma.

This and other objects and features are achieved, according to the present invention, by an apparatus for producing and sustaining a glow discharge plasma in a plasma discharge space according to claim 1.

Compared to the prior art solution, in the present invention, the stabilisation means are connected between the electrodes and the power supply means, such that the plasma discharge space is not obstructed by the introduction of an electrically conductive screen or the like, and the stabilisation means are arranged for counteracting fast current variations produced in the plasma within fractions of a microsecond.

In an embodiment according to the present invention, the stabilisation means are designed for energizing the electrodes providing a negative feedback to fast plasma current variations in the plasma causing the glow to arc transition as discussed above.

In a further embodiment of the invention, the stabilisation means are arranged for decreasing the plasma energizing or excitation voltage proportional to the rate of plasma current increase and/or to an increase of electromagnetic field radiation by the plasma.

That is, in order to prevent plasma instabilities initiated by low current streamers, the stabilization means are arranged in such a way that a negative voltage feedback is not only provided to a plasma current increase but also to a plasma electromagnetic radiation increase. In this manner filamentary discharges in the plasma can be effectively avoided.

In a preferred embodiment of the apparatus according to the present invention, the stabilization means are arranged for providing none or a negligible negative feedback or even a positive feedback to the energizing of the plasma at breakdown thereof.

This embodiment of the present invention is based on the insight that a negative feedback operation of the stabilisation means is not functional during plasma breakdown. When the plasma develops explosively at breakdown, decrease of the energizing or excitation voltage is not a guarantee that the plasma current will start to decrease. Near breakdown of the plasma, the plasma has a negative resistance, such that the current in fact will increase faster if the voltage is decreased.

From experimentally obtained data, it has been shown that the solution according to the present invention results in a very stable plasma for a variety of different supply gases, excitation conditions, electrode designs and electrode spacings.

The stabilization means may take various forms, among which a current dependent variable electric impedance, in particular an inductive impedance.

Following the preferred embodiment of the present invention, the current dependent variable electric impedance has to show a non-linear behavior. That is, at plasma breakdown the electric impedance has to substantially decrease in order not to reduce the energizing or excitation voltage applied to the electrodes of the APG system. This to effectively prevent the reduction of the current amplitude during and after the critical phase at plasma breakdown.

Preferably, the stabilization means are arranged for a substantial decrease of impedance at a plasma current density above approximately 0.2 mA/cm$^2$. A decrease of impedance of at least one order of magnitude appears to be sufficient. In the case of an impedance comprised of a resistive and an inductive part, reduction of the inductive part is essential for avoiding oscillations of the plasma current during plasma breakdown.

In a practical embodiment of the apparatus according to the present invention, the stabilization means comprise inductor means. Those skilled in the art will appreciate that inductor means, dependent on their inductance value, generate voltages opposed to the rate or speed of the magnetic flux variation and the current variation of the APG..

By connecting the inductor means and at least one of the electrodes in series to the power supply, a very simple electric circuit is obtained. For reasons of symmetry and obtaining a uniform as possible plasma, in an example each of the el ectrodes of the APG system individually is connected in series by inductor means to the power supply. In the case of an APG system comprising a plurality of electrodes, either oppositely or adjacently arranged, each of the electrodes may be connected by inductor means to the power supply of the APG system. These inductor means my differ in their inductance value, among others dependent on the size of the corresponding electrode.

The inductor means, in a yet further example, may comprise electronic inductor circuitry which, as such, are known to the skilled person. In an example, the inductor means comprise choke coil means. Provided suitably designed, choke coil means may show the required non-linear behavior at plasma breakdown as discussed above.

Choke coil means having a core of ferromagnetic material comprising any of the group of ferrite which can saturate at low magnetic fields of the order of 100 mT and which can operate at MHz frequencies, can be suitably designed to provide a reduced impedance or inductance required at plasma breakdown.

That is, by designing the core such that it saturates at plasma current values occurring during plasma breakdown, the impedance of the choke coil will reduce and large voltage variations will be avoided, and thereby additional plasma instability due to the choke coil. By connecting the choke coil means directly in series with the power supply and the electrodes of the APG, the saturation effect will be effected by the plasma discharge current.

The use of inductors as such is a standard method in the design of electronic circuitry for the filtering of high frequency voltage oscillations. However, those skilled in the art will appreciate that the fast current variations associated with the plasma filamentation are rather current oscillations (plasma is the equivalent of a low impedance current source) and not voltage oscillations, and their damping is not straightforward as disclosed above.

In an example, the inductor means, i.e. the choke coil means, can be designed for having an inductance of less then 10 H once the plasma has been produced. The inductance of the choke coil before saturation can be selected using the formula given below:

$$L \approx \frac{10^5}{I_{max}\tau}$$

wherein : L is the inductance of the choke coil;
$I_{max}$ is the amplitude of current (without the use of inductor means);
$\tau$ is the breakdown development time (without the use of inductor means).

However, as a rule of thumb, the inductance of a choke coil before saturation has to be chosen such that the resonance frequency of the resonant circuit formed by the choke coil and the stray capacitance of the APG reactor is in the MHz range.

In practice, the required inductance is of the order of 1-10 mH for a reactor having an electrode surface of 100 cm². 

In the event that the power supply means comprise an LC filter network .(impedance matching network) used for the purpose of achieving optimum power transfer and filtering of reflections of the plasma current towards the power source, in accordance with an embodiment, at least one of the electrodes is connected by the inductor means to the LC filter network.

As has been mentioned above in the case that the APG is powered through a transformer, the coupling line has a considerable inductance which is not satisfying the design criteria required for inductor stabilization means. In this case the coupling of the APG and the inductor means to the transformer equivalent inductance must be weak, in order to avoid that the coupling of the APG leads to an unwanted high inductance. To achieve this purpose, the reflection of the plasma current in the secondary of the transformer has to be reduced to a minimum, through the use of a filter network including LC, II ("Pi") or T networks.

However, the inductor means and the filter network have to be designed carefully for an effective damping of the high frequency components of the plasma current in the secondary of the transformer and the power source current. A further advantage of the solution according to an example is that the inductor means, such as the choke coil means, provide a significant contribution to the reduction of reflected power towards the power supply means.

Preferably, the inductor means should have a cut-off frequency above which their impedance is highly resistive, as a further measure of limitation of the current oscillations.

In order to have an effective as possible filtering of the undesired plasma electromagnetic radiation, the inductor means should be arranged in such a way that the flux of the plasma magnetic field through the inductor is maximized.

In an embodiment of this invention the inductor means are connected electrically as close as possible to one or both electrodes or to the plasma region.

In another embodiment of this invention the APG reactor itself is used as an inductor means by packing of the APG in ferromagnetic material.

In a preferred embodiment of the apparatus according to the invention, due to the fact that no screen for connecting the choke coil means and the like between the oppositely spaced electrodes is required, the electrodes can be spaced at a distance as close as from 0,01 mm upwards.

Due to the effective suppression of the current oscillations, in the apparatus according to the present invention, the gas for generating the plasma can be selected from a group comprising Helium, Argon, Nitrogen, Air, 0xygen, Carbon Dioxide, and a mixture comprising any of the gasses of the group.

In a preferred embodiment of the invention, the gas is a mixture of noble gas such as helium or argon and a chemically active gas such as air, oxygen and carbon dioxide. The gases may also comprise of specific chemical compositions which are usually involved in the chemical vapour deposition processes such as $SiH_4$, hydrocarbons, organosilicons such as TE0S and HMDSO, and organo-metallics.

In an example the slope of the AC voltage is arranged in such a manner that the pulse duration is larger than the period of the resonant frequency of the inductor means and the APG capacitance. In an example, the slope of the AC voltage is arranged in such a way that the time required for the development of plasma breakdown in all the volume of the APG is shorter than 200 ns. In this manner the stability of the plasma is substantially increased. Such conditions can be achieved if, for example, the AC voltage frequency is higher than 50 kHz.

In a still further example, the stabilisation means comprise pulse generator means providing short voltage pulses superimposed at said energizing voltage at said electrodes. The amplitude of the voltage pulses of the pulse generator is opposite to the AC powering or excitation voltage of the AC power supply means and proportional to the rate of current variation at lower currents and zero afterwards.

In the invention, such a pulse generator is formed by a power amplifier, having input or control terminals which connect to an inductor which is connected in series with one of the electrodes of the plasma chamber and the AC power supply means. One of the output terminals of the amplifier is connected with the power supply means and the other output terminal is connected with the other electrode of the plasma chamber. At its output, the power amplifier behaves like a power source, i.e. having a low output impedance.

The amplifier is switched on when a fast current variation is produced in the plasma, to be detected by the inductor, and is switched off when the current density exceeds a value of about 0.2 mA/cm$^2$. The amplitude of the voltage pulse has to be in the range of 100-500V and should have a slope of 100-200 V/$\mu$s.

The pulse generator circuit may be advantageously designed to provide a positive feedback to the energizing or excitation voltage at the electrodes at breakdown of the plasma, as disclosed above.

The apparatus according to the present invention can be used, in practice, for a wide variety of applications such as, but not limited to, a device for plasma surface treatment of a substrate, such as surface activation processes, which substrate can be glass, polymer, metal, etc., and for the generation of hydrophilic or hydrophobic surfaces; a plasma device for a chemical vapour deposition process; a plasma device for decomposition of gases containing volatile ozone component; a plasma device for removing toxital compounds from the gas phase; a plasma device for surface cleaning purposes such as in the sterilisation or dry cleaning processes.

The above-mentioned and other features and advantages of the invention are illustrated in the following description with reference to the enclosed drawings.

Brief Description of the Drawings

Fig. 1 shows, in a very schematic manner, an electric circuit diagram of the prior art APG apparatus as taught by US 5,414,324.

Fig. 2 shows, in a very schematic manner, an electric circuit diagram of a general embodiment of the apparatus according to the present invention.

Fig. 3 shows, in a very schematic manner, an electric circuit diagram of an example.

Fig. 4 shows a graph of typical plasma current oscillations which may occur in Nitrogen.

Fig. 5 shows, in a very schematic manner, an electric circuit diagram of the apparatus according to the present invention.

Figs. 6, 7 and 8 show, in a very schematic manner, electric circuit diagrams of experimental set-ups.

Fig. 9 shows a graph of plasma current waveforms in air, without the use of stabilisation means according to the experimental set up of Fig. 7.

Fig. 10 shows a graph of plasma current waveforms in air, with the use of stabilisation means according to the experimental set up of Fig. 8.

Fig. 11 shows, in a very schematic manner, an electric circuit diagram of a multi-electrode apparatus according to an example.

Detailed Description of the Drawings

Without the intention of limitation, the present invention will now be disclosed in more detail with respect to the attached drawings. In the drawings, like parts are designated by like reference numerals.

The circuit diagram of the prior art apparatus 10 disclosed by US 5,414,324, comprises a plasma chamber or plasma discharge space 11 and means 12 for supplying a gas or a gas mixture under atmospheric pressure conditions in the discharge space 11, indicated by arrow 9. For producing and sustaining a glow discharge plasma in the plasma discharge space 11, at least two oppositely spaced electrodes 13 and 14 in the discharge space 11 connect to AC power supply means 15, preferably AC power means, via an intermediate transformer stage 16.

For stabilizing current variations in the plasma in the discharge space 10, stabilisation means in the form of a choke coil 17 connect between system earth 19 and an electrically conductive screen 18 arranged between the electrodes 13, 14, and shown in dotted lines.

The screen 18 effectively limits the available space between the electrodes 13, 14 for treating a substrate or the like by the plasma. Further, the choke coil 17 need to be designed having a relatively high inductance of 100 H and more, which makes it very expensive and bulky.

As outlined in the introductory part, among others due to its relatively high time constant, the solution disclosed by US 5,414,324 will not protect against the formation of sparks and can only have a small effect at normal low current operating conditions and will affect only very slightly the plasma stability.

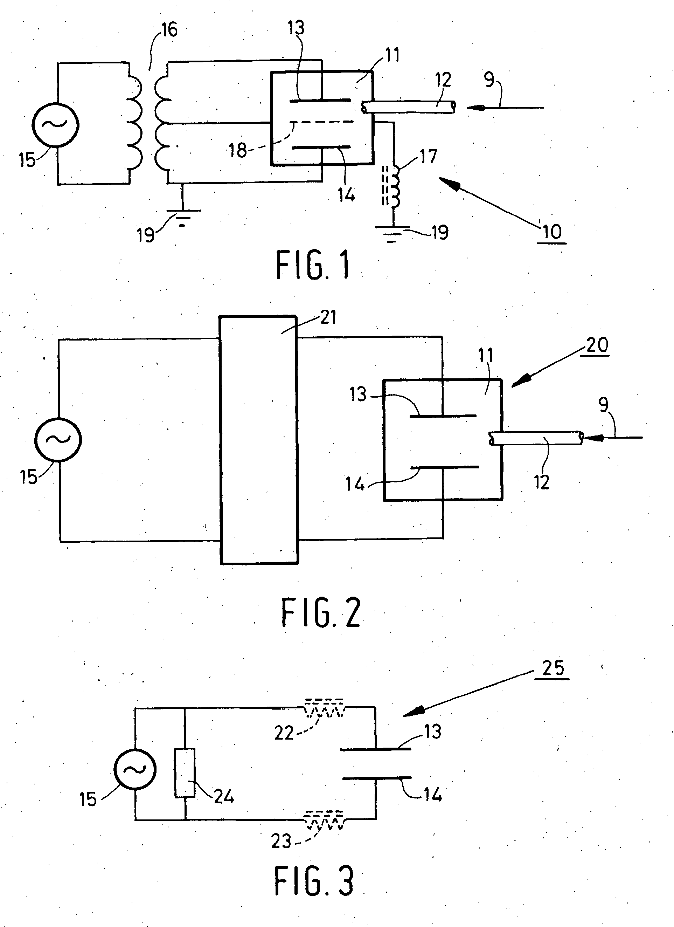

Fig. 2 shows a general circuit diagram 20 of the apparatus according to the present invention, wherein stabilisation means 21 connect between the electrodes 13, 14 and the power supply means 15, or the transformer stage 16, if available.

In accordance with the present invention, the stabilisation means 21 are arranged for decreasing plasma voltage proportional to the rate of plasma current variation and/or to the rate of the plasma magnetic field variation.

In a preferred embodiment of the invention, the stabilisation means comprise means having inductive properties, that is generating voltages proportional and opposed to the speed or rate of variation of the current and of the magnetic field radiated by plasma.

$$V_{ind} = - L \ dI/dt - d\Phi/dt$$

wherein: $V_{ind}$ = induced voltage [Volt]
$I$ = plasma current [Ampere]
$L$ = inductance [Henry].
$\Phi$ = flux of the magnetic field radiated by the plasma in the inductor means region.

The stabilisation means 21, in general, may comprise current dependent variable impedance means, such as electronic inductor means and/or electric inductor means like a coil, preferably a choke coil.

Fig. 3 shows a circuit diagram 25 in accordance with an example, wherein at least one choke coil, 22 or 23, series connect with an electrode 13 or 14, respectively, and the AC power supply means 15.

Reference numeral 24 designates an impedance matching circuit, such as an LC parallel circuit, mainly for the purpose of reducing reflective power from the electrodes 13, 14 back to the power supply means 15, or the transformer 16, if available. The impedance matching circuit 24 contributes to an increased plasma stability.

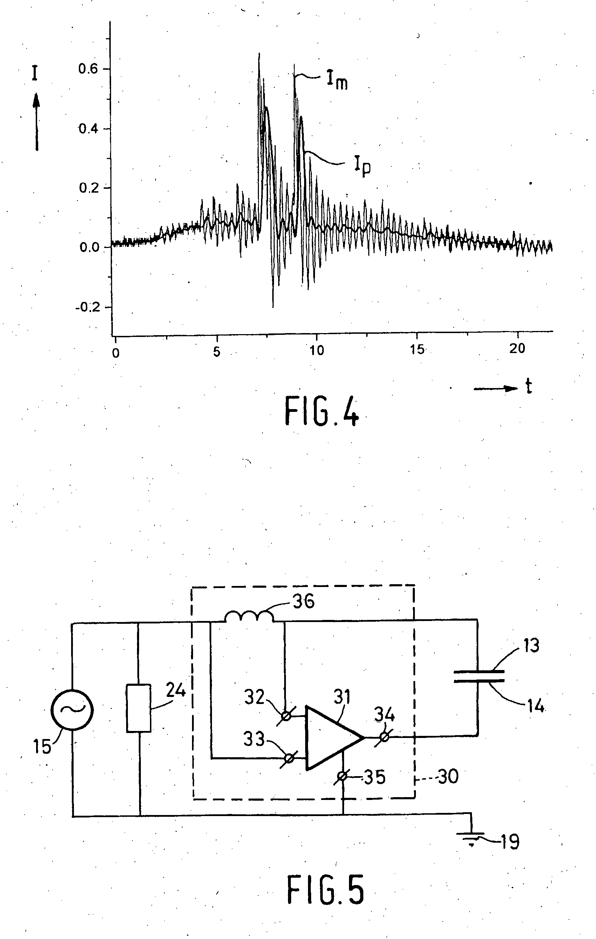

Fig. 4 shows a graph of typical plasma current oscillations which may occur in Nitrogen in an arrangement comprising the LC matching circuit 24, however not comprising the stabilisation means 21 according to the present invention. The electrodes are 1 mm spaced apart. Along the vertical axis plasma current I is displayed in A. The time t is displayed in $\mu$s along the horizontal axis. In Fig. 4 both the measured current $I_m$ and the plasma current $I_p$ are displayed.

As can be seen from Fig. 4, the impedance matching circuit 24 cannot filter high frequency current oscillations at the operating frequency of 12.8 kHz and, in general, frequencies in the order of 1-15 MHz. These oscillations are created by a fast plasma current increase due to impurities and the like, as disclosed in the introductory part.

Suppression of such plasma current oscillations having a relatively high speed or rate of change dI/dt are suppressed by the stabilisation means in accordance with the present invention. That is, during the fast increase of the plasma current, the stabilisation means reduce the voltage over the electrodes to below the breakdown voltage ($V_t$), such that the plasma discharge extinguishes.

Using choke coil means or in general inductor means in series with the power supply means, allows to increase the pulse duration, because the coil or coils will increase the voltage applied to the plasma when the current decreases.

However, during ignition, the plasma is very unstable, such that large voltage variations may result in extinguishing of the plasma.

In order to prevent such unwanted situations, in a preferred embodiment of the invention, the stabilisation means are arranged for a substantial decrease of impedance at plasma breakdown, such as, but not limited to a plasma current density above approximately 0.2 mA/cm2.

This is achieved, in an example by using choke coil means, wherein the or each choke coil comprises a core of ferromagnetic material. For radio frequency (RF) power supplies a core of ferrite is advantageous, designed such that the core comes magnetically in saturation at plasma currents which occur during ignition. As will be appreciated by those skilled in the art, due to the saturation of the core, the magnetic inductance of the choke coil decreases and large voltage variations are effectively prevented. The number of windings of a choke coil should be calculated such that the core comes into saturation for current densities in the order of 0.2 mA/cm2.

Arranging the stabilisation means for a decrease of impedance of at least one order of magnitude suffices for most of the APG systems. Preferably, to conclude in the saturation region, the choke coil means are substantially resistive above a specified frequency.

In the example shown in Fig. 3, for a typical ferrite core having a relative magnetic permeability of 2000-5000 the choke coils may be designed with an inductance of less than 10 H/cm2 and preferably between 0.01 mH/cm2 and 1 mH/cm2, and more preferably between 0.01 mH/cm2 and 0.1 mH/cm2 once the plasma has been ignited. The inductor means negative feedback provided to the plasma instabilities is efficient only at frequencies above 10 kHz.

To ensure a fast reaction time of the stabilising means, the inductance of the choke coil has to be chosen such that the resonance frequency of the resonant circuit formed by the choke coil and the stray capacitance of the APG reactor is in the MHz range. The magnetic core material of the choke coil, of course, has to be chosen to maintain its magnetic properties at frequencies in the MHz range.

Instead of a coil, a resistor may be inserted in series with the power supply of the APG reactor for damping oscillations within a fraction of a microsecond.

In the invention, shown in figure 5, the stabilisation means comprise pulse generator means 30, indicated in dashed lines, providing short voltage pulses when the plasma is established. The amplitude of the voltage pulses of the pulse generator 30 is opposite to the AC powering or excitation voltage of the AC power supply means 15 and proportional to the rate of current variation at lower currents and zero afterwards. Such a pulse generator 30 is formed by a power amplifier 31 the input or control terminals 32, 33 of which are connected to an inductor 36 which is connected in series with one of the electrodes 13 of the plasma and the AC power supply means 15. One of the output terminals 35 of the amplifier 31 is connected with the power supply means 15 and the other output terminal 34 is connected with the other electrode 14 of the plasma chamber. At its output, the power amplifier behaves like a power source, i.e. having a low output impedance.

The amplifier 31 is switched on when a fast current variation is produced in the plasma, to be detected by the inductor 36, and is switched off when the current density exceeds a value of about 0.2 mA/cm$^2$. The amplitude of the voltage pulse has to be in the range of 100-500V and should have a slope of 100-200 V/$\mu$s.

The pulse generator circuit 30 may be advantageously designed to provide a positive voltage feedback to the energizing or excitation voltage at the electrodes at breakdown of the plasma, as disclosed above. Breakdown of the plasma can be detected from saturation of the inductor 36 being designed as a choke coil, for example.

Several experiments have been conducted in order to show the improved operation of the arrangement according to the present invention:

Experiment 1.

Gas = Nitrogen;

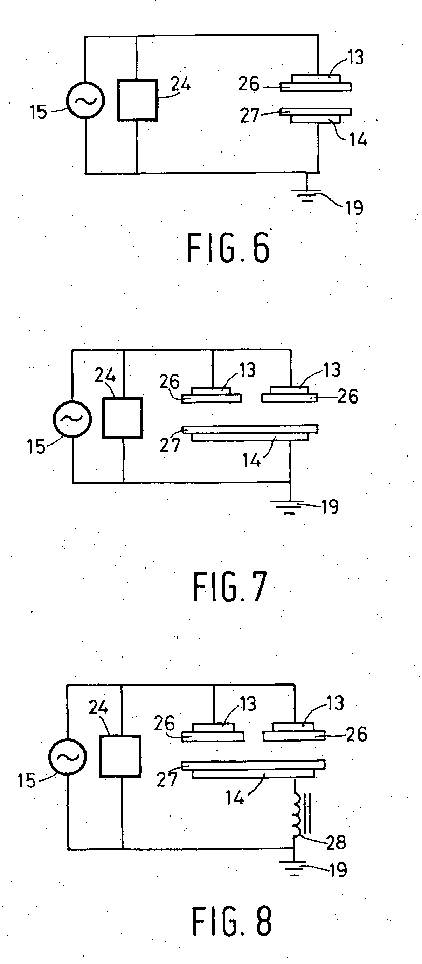

Experimental set-up in accordance with Fig. 6

The plasma is discharged in the space between the conductive electrodes 13 and 14, which are covered by dielectric material 26 of the type of Enamel and 27 of the of type PE, as shown in figure 6. The gap between the covered electrodes is 0.6 mm. N$_2$ gas is fed into the space between the dielectrics 26 and 27 with a flow rate of 15 L/min.

An AC voltage of 4 KV is applied to the electrodes in order to ignite the plasma. The frequency of the power supply 15 is 13 kHz. A common LC network 24 is parallel connected to the power supply 15.

The stability of the plasma is judged by analysing the I-V characteristics, which is described in U.S. Patent 6,299,948. In this experiment it is seen that the plasma is stable, i.e. there is only one current peak generated within the half cycle of the voltage wave.

Comparative 1.

Experimental set-up in accordance with Fig. 7

A similar plasma set-up as Experiment 1 is used, except that two pairs of electrodes 13, 14 are used (Fig. 6). The distance between one pair of electrodes to another is 5 mm. By applying the condition as mentioned in Experiment.1 , an unstable plasma was observed; i.e the I-V characteristic showed several current peaks within the half cycle of the voltage wave form.

Experiment 2.

Experimental set-up in accordance with Fig. 8

A Ferrite choke coil of a material type 3F3 ( MnZn Ferrite type), purchased from Ferroxcube Netherlands, having an induction of 6 mH is series connected to the lower electrode 14 and the power supply 15. Under the same gas, voltage and frequency conditions as mentioned in Comparative 1, a stable plasma was observed from the I-V characteristic.

Comparative 2.

Gas = Air.

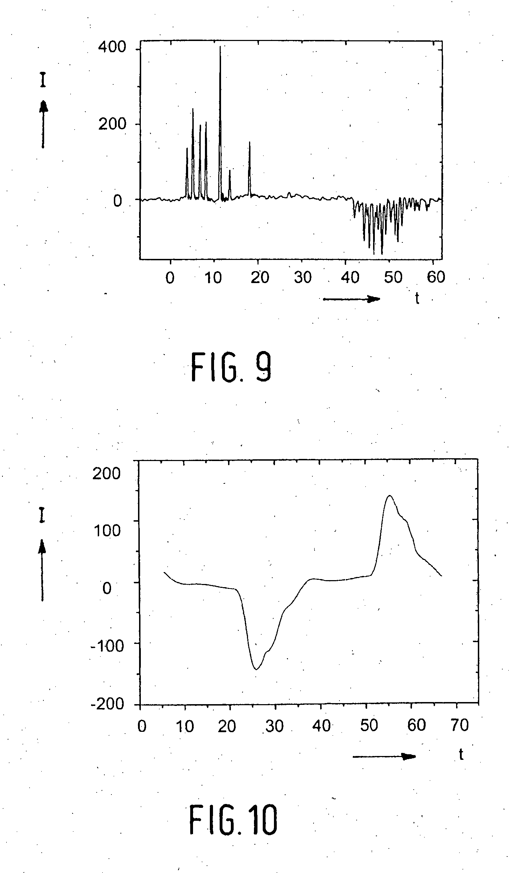

Plasma discharge was generated by using the set-up as described in experiment 1, except that air is used as gas. The flow rate of the air is 15 L/min., AC voltage applied 4 kV with frequency of 13 kHz. The gap between the electrodes is 1 mm. Observation from the I-V characteristic showed that there are a lot of high frequency pulses within a half cycle of the voltage wave form. See Fig. 9, wherein the current amplitude I is shown in mA along the vertical axis, and the time t in □s is displayed along the horizontal axis.

Experiment 3.

Same set up as comparative 2, wherein the ferrite coil as it is described in experiment 2, is placed in the lower electrode 14. The results show that a stable plasma is generated. See fig. 10, wherein the current amplitude I is shown in mA along the vertical axis, and the time t in □s is displayed along the horizontal axis.

Experiment 4.

Gas = Argon

Similar experiments as described in the experiments which have been performed for Nitrogen gas (Experiment 1 & 2 and Comparative 1) was repeated by using Argon gas. The gap between the electrode is 1.5 mm. The I-V characteristic showed similar results as in the case of Nitrogen gas.

From the experiments and comparatives above, it will be clear that the arrangement according to the present invention provides a significant improved plasma under atmospheric conditions, i.e. APG systems.

The invention can be advantageously applied in surface treatment applications of a substrate.

The invention is not limited to the embodiments and experiments disclosed and described above.

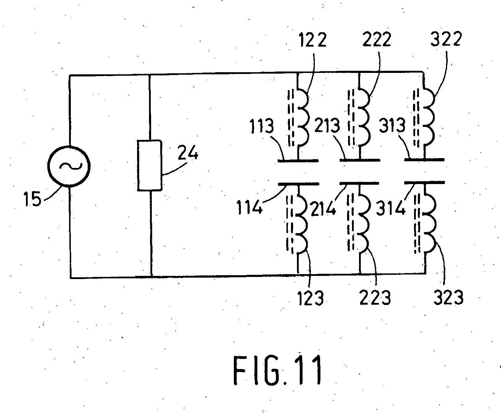

Fig. 11 shows an electric circuit diagram of an apparatus according to an example, comprising a plurality of pairs of oppositely arranged electrodes 113, 114; 213, 214; 313, 314. Each of the pairs may comprise a pair of choke coils 122, 123; 222, 223; 322, 323, respectively, in accordance with figure 3. Each of the pairs of choke coils may be designed differently, among others dependent on the surface dimensions of a particular electrode pair.

That is, one or a plurality of the choke coils may simultaneously operate in their saturation region while another or a plurality of the other coils is (not yet) operating in the non-saturation region. In such a configuration, all the de-stabilising signals to the plasma may be effectivel.y blocked. Of course other combinations of a plurality of series connected coils are feasible, each designed for operating in a specific region, for example, as disclosed above.

Although in the above oppositely positioned electrodes have been discussed and shown in the relevant figures, the example may also be practised with adjacently arranged electrode pairs or other configurations of electrodes of an APG apparatus.

Those skilled in the art will appreciate that many modifications and additions can be made without departing from the novel and inventive scope of the invention as defined in the appending claims.

## Claims

1. Apparatus for producing and sustaining a glow discharge plasma in a plasma discharge space comprising at least two oppositely spaced electrodes (13, 14), means (12) for supplying a gas or a gas mixture under atmospheric pressure conditions in said discharge space, AC power supply means (15) for voltage energizing said electrodes (13, 14), and electric stabilisation means (21) for stabilizing current variations in said plasma, said stabilisation means (21) are connected between said electrodes (13, 14) and said powder supply means (15), and are arranged for counteracting current variations produced in said plasma within fractions of a microsecond, **characterised in that** said stabilization means (21) comprise pulse generator means (30) arranged to provide voltage pulses superimposed at said energizing voltage at said electrodes (13, 14), and wherein said pulse generator means (30) is formed by a power amplifier (31) and by an inductor (36), said power amplifier (31) having input or control terminals (32, 33) which are connected to the inductor (36) which is connected in series with one of the electrodes (13) and the AC power supply means (15), wherein said power amplifier (31) has one output terminal (34) connected with the other electrode (14) and another output terminal (35) connected with said power supply means (15).

2. Apparatus according to Claim 1, wherein said stabilisation means (21) are designed for voltage energizing said electrodes (13, 14) providing a negative voltage feedback to a positive voltage feedback generated by said plasma.

3. Apparatus according to Claim 1 or 2, wherein said stabilisation means (21) are arranged for decreasing plasma voltage proportional to the rate of plasma current increase.

4. Apparatus according to any of the Claims 1 - 3, wherein said stabilisation means (21) are arranged for decreasing plasma voltage proportional to an increase in electromagnetic field radiation by said plasma.

5. Apparatus according to any of the Claims 1 - 4, wherein said stabilization means (21) are arranged for providing none or a negligible negative voltage feedback to the voltage energizing of said plasma at breakdown thereof.

6. Apparatus according to any of the Claims 1 - 4, wherein said stabilization means (21) are arranged for providing a positive voltage feedback to the voltage energizing of said plasma at breakdown thereof.

7. Apparatus according to any of the Claims 1 - 6, wherein said AC power supply means (15) comprise an impedance matching network (24), and at least one of said electrodes (13, 14) is connected by said inductor (36) to said impedance matching network (24).

8. Apparatus according to Claim 7, wherein said impedance matching network (24) comprises an LC filter network.

9. Apparatus according to any of the Claims 1 - 8, wherein said stabilisation means (21) are substantially resistive above a specified frequency.

10. Apparatus according to any of the Claims 1 - 9, wherein said stabilisation means (21) are electrically connected as close as practically possible to said at least one of said electrodes (13, 14).

11. Apparatus according to any of the Claims 1 - 10, wherein said discharge space and electrodes (13, 14) form an atmospheric pressure glow discharge reactor, and wherein said atmospheric pressure glow discharge reactor is used itself as an inductor means in that said atmospheric pressure glow discharge reactor is packed in a ferromagnetic material.

**12.** Apparatus according to any of the Claims 1 - 11, wherein said electrodes (13, 14) are oppositely spaced over a distance of between 0.01 mm and 3 cm.

**13.** Apparatus according to any of the Claims 1 - 12, wherein said gas is selected from a group comprising Helium, Argon, Nitrogen, Air, Oxygen, Carbon Dioxide, and a mixture comprising any of said gasses of said group.

**14.** Apparatus according to any of the Claims 1 - 13, wherein said gas is a mixture of a noble gas and a chemically active gas.

**15.** Apparatus according to any of the Claims 1 - 14, wherein said AC power supply means (15) are arranged for voltage energizing said electrodes, (13, 14) at a frequency between 10 kHz and 1 MHz

**16.** Device for treating a surface of a substrate, comprising an apparatus according of any of the Claims 1 - 15.

**Patentansprüche**

**1.** Vorrichtung zur Herstellung und Aufrechterhaltung eines Glimmentladungsplasmas in einem Plasmaentladungsraum, die mindestens zwei gegenüberliegende Elektroden (13, 14), Mittel (12) zum Bereitstellen eines Gases oder eines Gasgemisches unter atmosphärischen Druckbedingungen in dem Entladungsraum, eine Wechselstromversorgungseinrichtung (15) zum Spannungserregen der Elektroden (13, 14) und elektrische Stabilisierungsmittel (21) zum Stabilisieren von Stromschwankungen in dem Plasma umfasst, wobei die Stabilisierungsmittel (21) zwischen den Elektroden (13, 14) und der Stromversorgungseinrichtung (15) angeschlossen sind und dazu eingerichtet sind, in dem Plasma erzeugten Stromschwankungen innerhalb von Bruchteilen einer Mikrosekunde entgegenzuwirken, **dadurch gekennzeichnet, dass** die Stabilisierungsmittel (21) ein Pulsgeneratormittel (30) umfassen, das dazu eingerichtet ist, sich mit der Erregerspannung an den Elektroden (13, 14) überlagernde Spannungsimpulse bereitzustellen, und wobei das Pulsgeneratormittel (30) durch einen Leistungsverstärker (31) und einen Induktor (36) gebildet ist, wobei der Leistungsverstärker (31) Eingangs- oder Steueranschlüsse (32, 33) aufweist, die mit dem Induktor (36) verbunden sind, der in Reihe mit einer der Elektroden (13) und der Wechselstromversorgungseinrichtung (15) verbunden ist, wobei der Leistungsverstärker (31) einen Ausgangsanschluss (34) hat, der mit der anderen Elektrode (14) verbunden ist, und einen weiteren Ausgangsanschluss (35) hat, der mit der Stromversorgungseinrichtung (15) verbunden ist.

**2.** Vorrichtung nach Anspruch 1, wobei die Stabilisierungsmittel (21) zum Spannungserregen der Elektroden (13, 14) gestaltet sind, um eine negative Spannungsrückkopplung zu einer durch das Plasma erzeugten positiven Spannungsrückkopplung bereitzustellen.

**3.** Vorrichtung nach Anspruch 1 oder 2, wobei die Stabilisierungsmittel (21) zur Verringerung der Plasmaspannung proportional zu der Rate der Plasmastromerhöhung eingerichtet sind.

**4.** Vorrichtung nach einem der Ansprüche 1 - 3, wobei die Stabilisierungsmittel (21) zur Verringerung der Plasmaspannung proportional zu einer Erhöhung der elektromagnetischen Feldstrahlung durch das Plasma eingerichtet sind.

**5.** Vorrichtung nach einem der Ansprüche 1 - 4, wobei die Stabilisierungsmittel (21) eingerichtet sind, keine oder eine vernachlässigbare negative Spannungsrückkopplung zum Spannungserregen des Plasmas bei einem Zusammenbruch davon bereitzustellen.

**6.** Vorrichtung nach einem der Ansprüche 1 - 4, wobei die Stabilisierungsmittel (21) eingerichtet sind, eine positive Spannungsrückkopplung zum Spannungserregen des Plasmas bei einem Zusammenbruch davon bereitzustellen.

**7.** Vorrichtung nach einem der Ansprüche 1 - 6, wobei die Wechselstromversorgungseinrichtung (15) ein Impedanz-Anpassungsnetzwerk (24) umfasst, und mindestens eine der Elektroden (13, 14) über den Induktor (36) an das Impedanz-Anpassungsnetzwerk (24) angeschlossen ist.

**8.** Vorrichtung nach Anspruch 7, wobei das Impedanz-Anpassungsnetzwerk (24) ein LC Filternetzwerk umfasst.

**9.** Vorrichtung nach einem der Ansprüche 1 - 8, wobei die Stabilisierungsmittel (21) im Wesentlichen resistiv oberhalb einer bestimmten Frequenz sind.

**10.** Vorrichtung nach einem der Ansprüche 1 - 9, wobei die Stabilisierungsmittel (21) so nahe wie praktisch möglich an die zumindest eine Elektrode (13, 14) angeschlossen sind.

**11.** Vorrichtung nach einem der Ansprüche 1 - 10, wobei der Entladungsraum und die Elektroden (13, 14) einen Atmosphärendruck-Glimmentladungsreaktor bilden, und wobei der Atmosphärendruck-Glimmentladungsreaktor selbst als ein Induktormittel verwendet wird, indem der Atmosphärendruck-Glimmentladungsreaktor von einem ferromagnetischen Material ummantelt ist.

12. Vorrichtung nach einem der Ansprüche 1 - 11, wobei die Elektroden (13, 14) einander gegenüberliegend mit einem Abstand von zwischen 0,01 mm und 3 cm beabstandet sind.

13. Vorrichtung nach einem der Ansprüche 1 - 12, wobei das Gas aus einer Gruppe ausgewählt ist umfassend Helium, Argon, Stickstoff, Luft, Sauerstoff, Kohlendioxid und ein Gemisch umfassend beliebige Gase dieser Gruppe.

14. Vorrichtung nach einem der Ansprüche 1 - 13, wobei das Gas ein Gemisch eines Edelgases und eines chemisch aktiven Gases ist.

15. Vorrichtung nach einem der Ansprüche 1 - 14, wobei die Wechselstromversorgungseinrichtung (15) zum Spannungserregen der Elektroden (13, 14) mit einer Frequenz zwischen 10 kHz und 1 MHz eingerichtet ist.

16. Einrichtung zur Behandlung einer Oberfläche eines Substrats, umfassend eine Vorrichtung nach einem der Ansprüche 1 - 15.

## Revendications

1. Appareil pour produire et entretenir un plasma à décharge luminescente dans un espace de décharge de plasma comprenant au moins deux électrodes (13, 14) espacées en se faisant face, des moyens (12) pour fournir un gaz ou un mélange de gaz dans des conditions de pression atmosphérique dans ledit espace de décharge, des moyens d'alimentation alternative (15) pour alimenter en tension lesdites électrodes (13, 14), et des moyens de stabilisation électrique (21) pour stabiliser les variations de courant dans ledit plasma, lesdits moyens de stabilisation (21) étant connectés entre lesdites électrodes (13, 14) et lesdits moyens d'alimentation (15) et étant agencés pour contrecarrer les variations de courant produites dans ledit plasma dans les limites de fractions d'une microseconde, **caractérisé en ce que** lesdits moyens de stabilisation (21) comprennent des moyens de génération d'impulsions (30) agencés pour fournir des impulsions de tension superposées à ladite tension d'alimentation aux dites électrodes (13, 14), et dans lequel lesdits moyens de génération d'impulsions (30) sont formés par un amplificateur de puissance (31) et par une inductance (36), ledit amplificateur de puissance (31) comportant des bornes d'entrée ou de commande (32, 33) qui sont connectées à l'inductance (36) laquelle est connectée en série avec l'une des électrodes (13) et les moyens d'alimentation alternative (15), dans lequel ledit amplificateur de puissance (31) a une borne de sortie (34) connectée à l'autre électrode (14) et une autre borne de sortie (35) connectée aux dits moyens d'alimentation (15).

2. Appareil selon la revendication 1, dans lequel lesdits moyens de stabilisation (21) sont conçus pour alimenter en tension lesdites électrodes (13, 14) en fournissant une rétroaction de tension négative à une rétroaction de tension positive générée par ledit plasma.

3. Appareil selon la revendication 1 ou 2, dans lequel lesdits moyens de stabilisation (21) sont agencés pour diminuer la tension de plasma proportionnellement au taux d'augmentation du courant de plasma.

4. Appareil selon l'une quelconque des revendications 1 à 3, dans lequel lesdits moyens de stabilisation (21) sont agencés pour diminuer la tension de plasma proportionnellement à une augmentation du rayonnement de champ électromagnétique par ledit plasma.

5. Appareil selon l'une quelconque des revendications 1 à 4, dans lequel lesdits moyens de stabilisation (21) sont agencés pour ne fournir aucune rétroaction de tension négative ou pour fournir une rétroaction de tension négative négligeable à l'alimentation en tension dudit plasma lors du claquage de celui-ci.

6. Appareil selon l'une quelconque des revendications 1 à 4, dans lequel lesdits moyens de stabilisation (21) sont agencés pour fournir une rétroaction de tension positive à l'alimentation en tension dudit plasma lors du claquage de celui-ci.

7. Appareil selon l'une quelconque des revendications 1 à 6, dans lequel lesdits moyens d'alimentation alternative (15) comprennent un réseau d'adaptation d'impédance (24), et au moins l'une desdites électrodes (13, 14) est connectée par ladite inductance (36) au dit réseau d'adaptation d'impédance (24).

8. Appareil selon la revendication 7, dans lequel ledit réseau d'adaptation d'impédance (24) comprend un réseau de filtrage LC.

9. Appareil selon l'une quelconque des revendications 1 à 8, dans lequel lesdits moyens de stabilisation (21) sont sensiblement résistifs au-dessus d'une fréquence spécifiée.

10. Appareil selon l'une quelconque des revendications 1 à 9, dans lequel lesdits moyens de stabilisation (21) sont connectés électriquement aussi près que possible en pratique à ladite au moins une desdites électrodes (13, 14).

11. Appareil selon l'une quelconque des revendications 1 à 10, dans lequel ledit espace de décharge et les électrodes (13, 14) forment un réacteur de décharge luminescente à pression atmosphérique, et dans lequel ledit réacteur de décharge luminescente à pression atmosphérique est utilisé lui-même en tant que moyens formant inductance en ce que ledit réacteur de décharge luminescente à pression atmosphérique est enfermé dans un matériau ferromagnétique.

12. Appareil selon l'une quelconque des revendications 1 à 11, dans lequel lesdites électrodes (13, 14) sont espacées en se faisant face d'une distance entre 0,01 mm et 3 cm.

13. Appareil selon l'une quelconque des revendications 1 à 12, dans lequel ledit gaz est sélectionné dans un groupe comprenant l'hélium, l'argon, l'azote, l'air, l'oxygène, le dioxyde de carbone, et un mélange comprenant l'un quelconque desdits gaz dudit groupe.

14. Appareil selon l'une quelconque des revendications 1 à 13, dans lequel ledit gaz est un mélange d' un gaz noble et d'un gaz chimiquement actif.

15. Appareil selon l'une quelconque des revendications 1 à 14, dans lequel lesdits moyens d'alimentation alternative (15) sont agencés pour alimenter en tension lesdites électrodes (13, 14) à une fréquence entre 10 kHz et 1 MHz.

16. Dispositif pour traiter une surface d'un substrat, comprenant un appareil selon l'une quelconque des revendications 1 à 15.

FIG. 1

FIG. 2

FIG. 3

FIG.4

FIG.5

FIG. 6

FIG. 7

FIG. 8

FIG. 9

FIG. 10

FIG.11

**EP 1 381 257 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5414324 A
- US 5895558 A
- US 4679007 A
- US 5882492 A
- US 5965034 A
- US 6299948 B